**Europäisches Patentamt**

**European Patent Office**

**Office européen des brevets**

(19)

(11) Veröffentlichungsnummer: **0 181 534**
**B1**

(12) **EUROPÄISCHE PATENTSCHRIFT**

(45) Veröffentlichungstag der Patentschrift:
13.09.89

(51) Int. Cl.⁴: **H 05 K 7/02, B 60 R 16/02**

(21) Anmeldenummer: **85113370.2**

(22) Anmeldetag: **22.10.85**

(54) Einrichtung für ein Kraftfahrzeug.

(30) Priorität: **27.10.84 DE 3439410**

(43) Veröffentlichungstag der Anmeldung:
**21.05.86 Patentblatt 86/21**

(45) Bekanntmachung des Hinweises auf die Patenterteilung:
**13.09.89 Patentblatt 89/37**

(84) Benannte Vertragsstaaten:
**AT DE FR GB IT SE**

(56) Entgegenhaltungen:
**DE-A-3 050 444**
**DE-A-3 115 276**
**DE-U-68 034 130**
**FR-A-2 440 024**
**FR-A-2 502 887**

(73) Patentinhaber: **Stribel GmbH, Benzstrasse, D-7443 Frickenhausen (DE)**

(72) Erfinder: **Stribel, Hans Peter, Ob der Luthereiche 26, D-7440 Nürtingen (DE)**

EP 0 181 534 B1

## Beschreibung

Die Erfindung betrifft eine Einrichtung für ein Kraftfahrzeug mit den Merkmalen des Oberbegriffs des Anspruchs 1.

Eine derartige Einrichtung, wie sie beispielsweise aus dem DE-GM-618 034 130 bekannt ist, wird zumeist kurz als Zentralelektrik bezeichnet, die ein kompaktes Gehäuse mit festen Leiterbahnen in verschiedenen Ebenen aufweist. Eine solche Zentralelektrik hat im wesentlichen eine Verteilerfunktion, um die elektrischen Verbraucher, wie zum Beispiel Lampen, Scheibenwischer, Blinker, Heizungen, Magnetventile und dergleichen, über Leitungen und Kabelbäume mit Spannung beziehungsweise Strom zu versorgen, wobei auch die Möglichkeit besteht, die Funktionstüchtigkeit der Verbraucher zu überwachen sowie etwaige Fehler festzustellen und zu melden. Die funktionsgerechte Ansteuerung der elektrischen Verbraucher erfolgt dabei über Schaltgeräte, die zumeist steckbar auf der Oberseite der Zentralelektrik angeordnet sind, während die Kabelbäume zumeist an der Unterseite der Zentralelektrik mittels entsprechenden Steckverbindern befestigt sind. Die aufgesteckten Schaltgeräte beinhalten bei den bekannten Zentralelektriken oftmals eine elektronische Steuerschaltung, welche die jeweilige Ansteuerfunktion des zugehörigen elektrischen Verbrauchers erfüllt, während der eigentliche Schaltvorgang selbst für das Ein- und Ausschalten des Verbrauchers über ein im Schaltgerät angeordnetes Relais erfolgt. Durch die somit verhältnismäßig aufwendigen Schaltgeräte besteht ein erheblicher Nachteil, da für jedes einzelne Schaltgerät eine separate Elektroniksteuerung für jeden einzelnen Verbraucher vorgesehen werden muß. Ein weiterer Nachteil besteht darin, daß im Falle eines defekten Relais im Schaltgerät mit diesem gleichzeitig auch die baueinheitliche Elektroniksteuerung beim Austausch des Schaltgerätes zwangsläufig mit verworfen wird, wodurch eine zusätzliche Kostenbelastung entsteht. Um Spannungsspitzen, Überspannungen und negative Impulsen im Bordnetz des Kraftfahrzeugs zu begegnen, muß außerdem jedes einzelne Schaltgerät gegen diese unerwünschten Beanspruchungen durch zusätzliche bauelementaufwendige Schaltungsmaßnahmen abgeblockt werden.

Aus der DE-A-3 115 276 ist eine Einrichtung für ein Kraftfahrzeug bekannt, die einen Systemaufbau aufweist, der aus einer integrierten Schaltereinheit, einem Zentralprozessor, Ortsprozessoren, Verkabelungsmoduln und einer integrierten Kontrollanzeige besteht. Die Befehlssignale von den Schaltern gehen, nachdem sie im Zentralprozessor verarbeitet worden sind, an einen Ortsprozessor weiter und steuern dort die entsprechenden Endeinheiten an.

Aus der FR-A-2 440 024 ist ferner eine elektrische Zentraleinheit für ein Kraftfahrzeug bekannt, die eine als Microprozessor ausgebildete Verarbeitungseinheit, Verteilungseinheiten sowie Karten bzw. Leiterplatten mit Stromkreisen aufweist, wobei die Verarbeitungseinheit eine selbständige Einheit sein kann oder in dem Armaturenbrett des Kraftfahrzeugs eingebaut werden kann.

Die Aufgabe der Erfindung besteht darin, eine Einrichtung mit den Merkmalen des Oberbegriffs des Anspruchs 1 dahingehend weiterzubilden, daß eine kompakte und kostengünstige Zusammenfassung mehrerer verschiedener Elektroniksteuerungen zur Ansteuerung verschiedener elektrischer Verbraucher des Kraftfahrzeugs in von den Schaltgeräten unabhängiger Anordnung erzielt wird und die Voraussetzung für eine erhebliche Erweiterung der auszuführenden Steuerfunktionen auf kleinstem Raum gegeben ist.

Diese Aufgabe wird bei einer Einrichtung für ein Kraftfahrzeug mit den Merkmalen des Oberbegriffs durch die kennzeichnenden Merkmale des Anspruchs 1 gelöst.

Bevorzugte Ausgestaltungen und Weiterbildungen sowie weitere Vorteile und wesentliche Einzelheiten der Erfindung sind den Merkmalen der Unteransprüche, der nachfolgenden Beschreibung und der Zeichnung zu entnehmen, die in schematischer Darstellung bevorzugte Ausführungsformen als Beispiel zeigt. Es stellen dar:

Fig. 1 eine Schnittansicht einer erfindungsgemäßen Zentralelektrik mit einem im Gehäuse integrierten Mikrocomputer zur Ansteuerung der elektrischen Verbraucher eines Kraftfahrzeugs,

Fig. 2 eine Draufsicht auf eine vergrößerte schematische Prinzipdarstellung des Mikrocomputers ähnlich der Fig. 1,

Fig. 3 eine Draufsicht auf einen Teil der Zentralelektrik ähnlich der Fig. 1 und

Fig. 4 eine isometrische Darstellung eines Mikrocomputers in einem Steckergehäuse, das auf die Oberseite der Zentralelektrik gemäß Fig. 3 aufsteckbar ist.

Die in der Zeichnung dargestellte erfindungsgemäße Zentralelektrik ist für den Einbau in ein Kraftfahrzeug bestimmt und ist so ausgeführt, daß hier viele elektrische Verbraucherstromkreise und Steuerleitungen zentral mittels Steckverbindungen zusammengefaßt werden können. Die Zentralelektrik 1 besitzt ein aus Kunststoff bestehendes Gehäuse 2, das einen Unterteil 3 und einen Oberteil 4 besitzt. Der Oberteil 4 weist eine obere Deckwand 5 und Seitenwände 6 auf, die an Raststellen 7 mit dem Unterteil 3 verbunden sind. Dadurch ist das Gehäuse 2 im wesentlichen ringsum geschlossen.

Am Unterteil 3 des Gehäuses 2 sind mehrere rechteckförmige Schächte 8 angeformt, die nach unten hin offen sind und in die verschiedene Elektrostecker unverwechselbar und verdrehsicher eingeschoben werden können. Die in die rechteckförmigen Schächte 8 eingeschobenen Elektrostecker sind durch die nach unten abstrebenden Schachtwände weitgehend gegen Verschmutzung geschützt.

Im Gehäuse 2 befinden sich elektrische Leiterbahnen 9, die bevorzugt aus leitenden Metallblechen bestehen und entsprechend ausgestanzt sind. Die Leiterbahnen 9 sind in mehreren Ebenen über einander gelagert und gegeneinander durch plattenförmige Zwischenisolationen 10 elektrisch isoliert. An mehreren Leiterbahnen 9 sind sowohl kreiszylindrische als auch flachrechteckförmige Stecker 11, 11' angeordnet, die den Unterteil 3 des Gehäuses 2 nach unten hin durchsetzen und in die Schächte 8 hineinragen.

Weiterhin sind an der Innenseite des Unterteils 3 für eine einwandfreie Isolierung und Abstandshaltung zwischen den Leiterbahnen 9 Isolierhülsen 12 angeformt, die sich in Richtung nach oben erstrecken. Diese Isolierhülsen 12 besitzen kreiszylindrische oder rechteckförmige Durchgangslöcher, die entsprechend den Querschnitten der Stecker 11, 11' geformt sind, so daß letztere in den Isolierhülsen 12 weitgehend spielfrei gelagert sind.

An den anderen Endbereichen der Leiterbahnen 9 sind materialeinheitlich angeformte Stützstege 13 angeordnet, die an einer Biegestelle 14 rechtwinklig aus der Ebene der Leiterbahnen 9 nach oben umgebogen sind, so daß sich die Stützstege 13 in Richtung zur Deckwand 5 hin erstrecken. Dabei sind die plattenförmigen Leiterbahnen 9 der oberen Ebenen jeweils so geformt und freigestanzt, daß die Stützstege 13 die übergeordneten Leiterbahnen 9 in entsprechenden Aussparungen beziehungsweise Ausklinkungen durchsetzen. Die Einhaltung der Isolationsabstände in den Aussparungen und Ausklinkungen kann zusätzlich durch entsprechende Isolationsstege der Zwischenisolation 10 unterstützt sein, so daß eine exakte und unverschiebbare Lagerung der Leiterbahnen 9 mit den angeformten Stützstegen 13 im Gehäuse 2 gewährleistet ist.

An den Stützstegen 13 sind die oberen Endbereiche als materialeinheitlich einstückig geformte Steckerbuchsen 15 ausgebildet, die sich alle in etwa in einer einzigen Ebene dicht unter der Deckwand 5 des Gehäuses 2 befinden. Über den oberen Öffnungsbereichen dieser Steckerbuchsen 15 sind in der Deckwand 5 Einsteckschlitze 16 ausgebildet, in welche die in die Steckerbuchsen 15 eingreifenden Flachstecker der Flachsicherungen 17 beziehungsweise der Schaltgeräte 18 (gestrichelt dargestellt) eingeführt werden können.

Die Steckerbuchsen 15 selbst weisen je eine parallel zum Einsteckschlitz 16 liegende Kontaktlasche 19 auf, der mindestens ein Kontaktdruckfinger 20 zugeordnet ist, der senkrecht zur Kontaktlasche 19 aufgerichtet ist, so daß die eine Schmalseite des Kontaktdruckfingers 20 gegen eine Breitseite der Kontaktlasche 19 gerichtet ist.

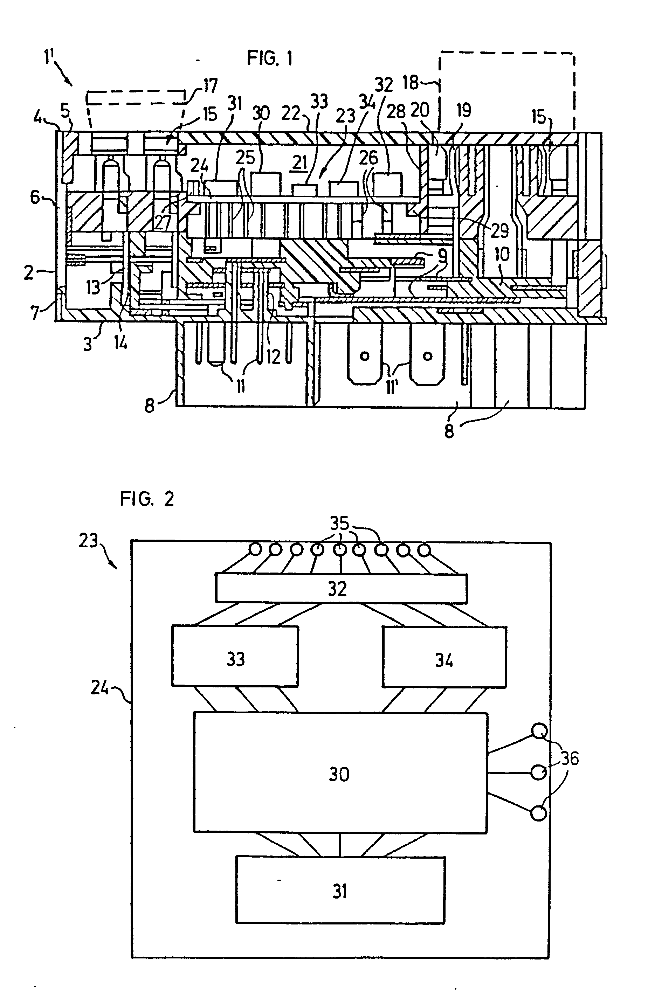

Die in der Fig. 1 dargestellte Zentralelektrik 1 weist über den Leiterbahnen 9 im Bereich zwischen den in der Zeichnung links dargestellten Steckerbuchsen 15 für die Flachsicherungen 17 und den in der Zeichnung rechts dargestellten Steckerbuchsen 15 für die Schaltgeräte 18 eine Ausnehmung 21 auf. Die Ausnehmung 21 ist oben mit einem Deckel 22 verschlossen, der hier bevorzugt in der Ebene der Deckwand 5 liegt. Der Deckel 22 kann lösbar befestigt sein. Es besteht jedoch auch die Möglichkeit, den Deckel 22 über der Ausnehmung 21 zum Beispiel durch Kleben oder Verschweißung fest anzuordnen, so daß ein absolut sicherer und dichter Abschluß gegeben ist.

In der Ausnehmung 21 des Gehäuses 2 ist ein Mikrocomputer 23 verdeckt gelagert, der im Prinzip ebenfalls in der Fig. 2 in einer Draufsicht dargestellt ist. Dieser Mikrocomputer 23 weist eine Leiterplatte 24 auf, deren nach unten abstrebende Leiterstege 25 mit den Leiterbahnen 9 im Gehäuse 2 zum Beispiel durch Löt- oder Schweißkontaktierung fest verbunden sind. Die Leiterplatte 24 kann auch mittels Steckerteilen 26 mit den Leiterbahnen 9 im Gehäuse 2 kontaktiert sein, wobei auch eine lösbare Kontaktierung möglich ist, wenn die Verbindung mit den Leiterbahnen 9 ausschließlich über die Steckerteile 26 erfolgt. An dem einen Randbereich der Leiterplatte 24 kann zudem eine Steckerleiste 27 vorgesehen sein, so daß eine Kontaktierung mit den Leiterbahnen 9 im Gehäuse 2 auch an einer Seite der Ausnehmung 21 erfolgen kann.

Die Leiterplatte 24 des Mikrocomputers 23 kann in der Ausnehmung 21 des Gehäuses 2 bevorzugt so festgelegt werden, daß Randbereiche der Leiterplatte 24 auf an den Seitenwandungen 28 ausgebildeten Vorsprüngen 29 fest aufliegen. Dazu kann eine Klipparretierung oder auch eine Schraubbefestigung zum Festhalten der Leiterplatte 24 in der Ausnehmung 21 vorgesehen sein.

Der Mikrocomputer 23 besitzt auf der Leiterplatte 24 im wesentlichen einen als elektronischen Rechner ausgebildeten Mikroprozessor 30, dem ein Programmspeicher 31 sowie eine Ein- und Ausgabeeinheit 32 und weitere Peripheriegeräte 33, 34, wie Schaltkreise und Treiberstufen zugeordnet sind. Der Mikrocomputer 23 vereinigt im wesentlichen die verschiedenen elektronischen Steuerungen für die elektrischen Verbraucher des Kraftfahrzeugs, die über die Schaltgeräte 18, welche nunmehr im wesentlichen nur noch ein Relais oder dergleichen zu beinhalten brauchen, betätigt beziehungsweise ein- oder ausgeschaltet werden. Der Mikrocomputer 23 vereinigt somit die unterschiedlichsten Steuerfunktionen, so daß für die Ansteuerung der elektrischen Verbraucher, wie zum Beispiel Scheinwerfer, Blinkleuchten, Scheibenwischer, Scheibenheizung, Scheibenheber und dergleichen, nicht mehr wie bisher einzelne elektronische Steuerungen in den Schaltgeräten vorgesehen werden müssen. An dem einen Rand bereich der Leiterplatte 24 können die elektrischen Ein- und Ausgänge 35 des Mikrocomputers 23 vorgesehen sein, während die Stromversorgung 36 für den Mikrocomputer 23 an einem anderen Randbereich der Leiterplatte 24 erkennbar ist.

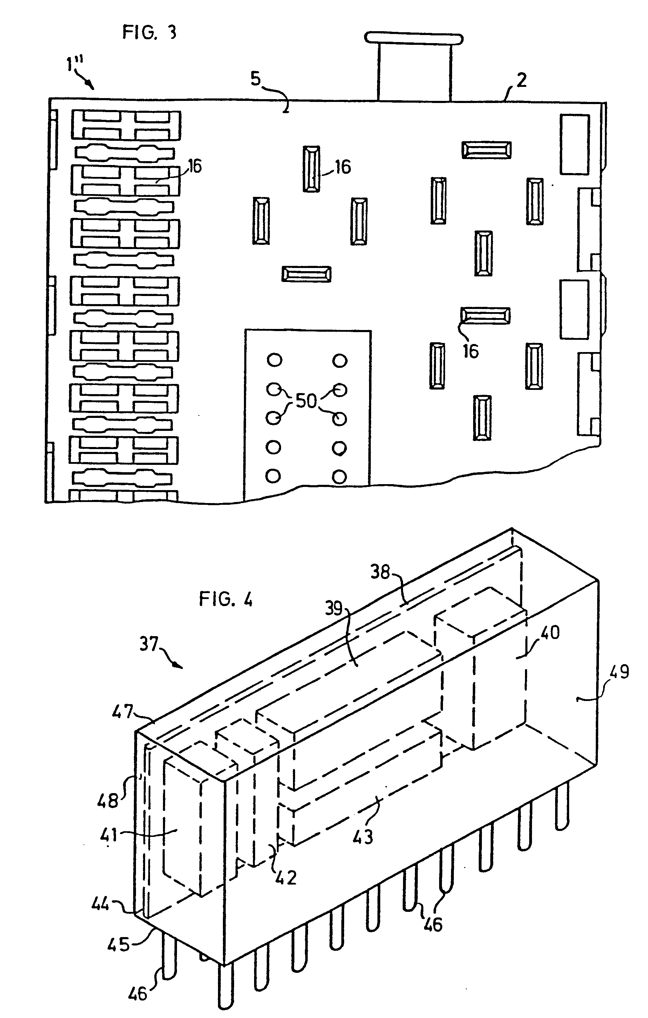

Bei dem in der Fig. 4 dargestellten Ausführungsbeispiel ist der Mikrocomputer 37 mit der Leiterplatte 38 und dem auf dieser angeordneten Mikroprozessor 39, dem Programmspeicher 40, der Ein- und Ausgabeeinheit 41 sowie den Peripheriegeräten 42, 43 in einem Steckergehäuse 44 angeordnet. Das Steckergehäuse 44 weist an seiner Grundplatte 45 Steckerstifte 46 auf, die nach unten hin vorstehen und beim vorliegenden Ausführungsbeispiel bevorzugt in zwei parallelen Reihen angeordnet sind. Die Steckerstifte 46 sind mit den Stromführungsbahnen der Leiterplatte 38 elektrisch verbunden.

Das Steckergehäuse 44 ist hier im wesentlichen als rechteckförmiger Zylinder ausgebildet, wobei die Haube 47 an der Grundplatte 45 durch eine Klippverbindung lösbar festgelegt sein kann oder durch Verschweißung oder Verklebung mit der Grundplatte 45 unlösbar fest verbunden ist. Die Leiterplatte 38 des Mikrocomputers 37 steht in ihrer Ebene senkrecht auf der Grundplatte 45 auf und befindet sich somit parallel zu den Steckerstiften 46 und parallel zu den Längsseitenwänden 48, 49. Die Leiterplatte 38 befindet sich dabei in der Nähe der hinteren Längsseitenwand 48, so daß zwischen dieser und der Rückseite der Leiterplatte 38 ein nur geringer Abstand besteht. Die Grundplatte 45 und die Haube 47 des Steckergehäuses 44 können zweckmäßig aus einem elektrisch isolierenden Kunststoff bestehen. Es kann aber auch günstig sein, zum Beispiel die Haube 47 aus einem Metallblech herzustellen.

Der im Steckergehäuse 44 befindliche Mikrocomputer 37 kann auf die Deckwand 5 des Gehäuses 2 der in der Fig. 3 dargestellten Zentralelektrik 1'' aufgesteckt werden. Dazu sind in der Deckwand Steckeraufnahmen 50 ausgebildet, unter denen sich im Gehäuse 2 angeordnete Steckbuchsen befinden, in die die Steckerstifte 46 des Steckergehäuses 44 eingreifen. Die Steckeraufnahmen 50 und die darunterliegenden Steckbuchsen sind demnach für eine einwandfreie Steckkontaktierung entsprechend der Anordnung und Ausführung der Steckerstifte 46 ausgebildet. Die Steckeraufnahmen 50 sind dazu in zwei parallelen Reihen angeordnet und befinden sich im Bereich zwischen den linken Einsteckschlitzen 16 für die einzusetzenden Kleinsicherungen 17 und den anderen Einsteckschlitzen 16 für die aufzusteckenden Schaltgeräte 18.

Mit der erfindungsgemäßen Zentralelektrik 1 wird der Vorteil einer erhöhten Funktionssicherheit erzielt, da gegenüber den bisherigen einzelnen elektronischen Ansteuerungen wesentlich weniger Bauelemente erforderlich sind. Ein etwa notwendiger Schaltgeräteaustausch ist wesentlich günstiger als bisher, da die integrierte Mikrocomputer-Steuerelektronik nunmehr zentral verbleibt und nicht verworfen wird. Ein weiterer Vorteil besteht darin, daß für die Mikrocomputer-Steuerelektronik der Zentralelektrik nur noch eine einzige Absicherung gegen Spannungsspitzen, Überspannungen und negative Impulse des Bordnetzes notwendig ist, wodurch eine einfache und kostengünstige Ausführung möglich ist. Darüber hinaus ist der Vorteil gegeben, daß praktisch ohne Mehraufwand die Möglichkeit zur Übernahme zusätzlicher vielfältiger Steuer- und Kontrollfunktionen zum Beispiel zur Überwachung der elektrischen Schaltkreise und zur Durchführung von Meldefunktionen über verschiedene Betriebszustände der elektrischen Verbraucher besteht.

**Patentansprüche**

1. Einrichtung für ein Kraftfahrzeug bestehend aus

a) einer Zentralelektrik (1) zum zentralen Anschluß elektrischer Bauteile, wie Kabelbäume, Steckverbinder, Sicherungen (17) und Schaltgeräte (18), elektronische Steuerungen für elektrische Verbraucher, wie Lampen, Scheibenwischer, Blinker, Heizungen, Magnetventile,

b) die Zentralelektrik (1) besitzt Leiterbahnen (9), die in mehreren Ebenen übereinander angeordnet sind,

c) die Leiterbahnen (9) sind in einem Gehäuse (2) der Zentralelektrik (1) vorgesehen,

gekennzeichnet durch die folgenden, für sich teilweise bekannten Merkmale:

d) die elektronischen Steuerungen (18) sind von den Schaltgeräten getrennt angeordnet,

e) an der Zentralelektrik (1) ist ein Mikrocomputer (23, 37) direkt angeordnet,

f) die elektronischen Steuerungen der Schaltgeräte (18) sind in dem Mikrocomputer (23, 37) zentral zusammengefaßt und

g) mit dem Mikrocomputer (23, 37) als an der Zentralelektrik (1) verbleibbare integrierte Mikrocomputer-Steuerelektronik ausgebildet,

h) die Mikrocomputer-Steuerelektronik der Zentralelektrik (1) ist durch eine einzige Sicherung gegen Spannungsspitzen, Überspannungen und negative Impulse des Bordnetzes absicherbar,

i) der Mikrocomputer (23, 37) besitzt eine Leiterplatte (24, 38) auf der mindestens ein als elektronischer Rechner ausgebildeter Mikroprozessor (30, 39) mit mindestens einem Programmspeicher (31, 40), mindestens einer Ein- und Ausgabeeinheit (32, 41) sowie zugeordnete Peripheriegeräte (33, 34, 42, 43) angeordnet sind,

j) die Leiterplatte (24, 38) des Mikrocomputers (23, 37) ist mit den Leiterbahnen (9) im Gehäuse (2) der Zentralelektrik (1) verbunden.

2. Einrichtung nach vorstehendem Anspruch, dadurch gekennzeichnet, daß der Mikrocomputer (23, 37) gegenüber am Unterteil (3) des Gehäuses (2) vorgesehenen Steckern (11, 11') in einer Ebene über den Leiterbahnen (9) angeordnet ist.

3. Einrichtung nach einem der vorstehenden Ansprüche, dadurch gekennzeichnet, daß der Mikrocomputer (23, 37) im Bereich zwischen Sicherungen (17) und die Schaltgeräte (18) aufnehmenden Steckerbuchsen (15) angeordnet ist.

4. Einrichtung nach einem der vorstehenden Ansprüche, dadurch gekennzeichnet, daß der Mikrocomputer (23) in einer Ausnehmung (21) des Gehäuses (2) versenkt gelagert ist.

5. Einrichtung nach einem der vorstehenden Ansprüche, dadurch gekennzeichnet, daß die den Mikrocomputer (23) beinhaltende Ausnehmung (21) des Gehäuses (2) mittels eines Deckels (22) verschlossen ist.

6. Einrichtung nach einem der vorstehenden Ansprüche, dadurch gekennzeichnet, daß die Leiterplatter (24) des Mikrocomputers (23) auf Vorsprüngen (29) an der Seitenwandung (28) der Ausnehmung (21) im Gehäuse (2) festgelegt ist.

7. Einrichtung nach einem der vorstehenden Ansprüche, dadurch gekennzeichnet, daß die Leiterplatte (24) des Mikrocomputers (23) über Leiterstege (25) mit den Leiterbahnen (9) im Gehäuse (2) fest verbunden (Lötverbindung) ist.

8. Einrichtung nach einem der vorstehenden Ansprüche, dadurch gekennzeichnet, daß die Leiterplatte (24) des Mikrocomputers (23) über Steckerteile (26) mit den Leiterbahnen (9) im Gehäuse (2) lösbar verbunden ist.

9. Einrichtung nach einem der vorstehenden Ansprüche, dadurch gekennzeichnet, daß die Leiterplatte (24) des Mikrocomputers (23) mittels einer am Randbereich vorgesehenen Steckerleiste (27) an einer Seite der Ausnehmung (21) mit den Leiterbahnen (9) des Gehäuses (2) kontaktierbar ist.

10. Einrichtung nach einem der vorstehenden Ansprüche, dadurch gekennzeichnet, daß der Mikrocomputer (37) mit der Leiterplatte (38) und dem auf dieser angeordneten Mikroprozessor (39), dem Programmspeicher (40), der Ein- und Ausgabeeinheit (41) sowie den Peripheriegeräten (42, 43) in einem Steckergehäuse (44) angeordnet ist, das mit hervorstehenden Steckerstiften (46) in Steckeraufnahmen (50) des Gehäuses (2) einsetzbar ist.

11. Einrichtung nach einem der vorstehenden Ansprüche, dadurch gekennzeichnet, daß das Steckergehäuse (44) des Mikrocomputers (37) im wesentlichen rechteckförmig gestaltet ist und daß die Steckerstifte (46) an einer Grundplatte (45) des Steckergehäuses (44) in parallelen Reihen angeordnet sind.

12. Einrichtung nach einem der vorstehenden Ansprüche, dadurch gekennzeichnet, daß die Leiterplatte (38) des Mikrocomputers (37) in ihrer Ebene parallel zu den Steckerstiften (46) und senkrecht zur Grundplatte (45) ausgerichtet und mit ihrer Rückseite in nur geringem Abstand zu der einen Seitenwand (48) im Steckergehäuse (44) angeordnet ist.

13. Einrichtung nach einem der vorstehenden Ansprüche, dadurch gekennzeichnet, daß das den Mikrocomputer (37) beinhaltende Steckergehäuse (44) mit den Steckerstiften (46) an der den Steckern (11, 11') an dem Unterteil (3) des Gehäuses (2) gegenüberliegenden Oberteil (4) im Bereich zwischen den Steckerbuchsen (15) der Sicherungen (17) und der Schaltgeräte (18) in die hier offenen Steckeraufnahmen (50) eingesetzt ist.

**Claims**

1. Apparatus for an automobile, consisting of
a) a central electrical unit (1) for the central connection of electrical components, such as cable harnesses, plug connectors, fuses (17) and switching devices (18), electronic controls for electrical consumer units, such as lamps, windscreen wipers, indicator lights, heaters, solenoid valves,
b) the central electrical unit (1) possesses conductor paths (9) which are disposed in several planes one above another,
c) the conductor paths (9) are provided in a housing (2) of the central electrical unit (1),
characterized by the following, partly known, features:
d) the electronic controls (18) are disposed separately from the switching devices,
e) a microcomputer (23, 37) is disposed directly at the central electrical unit (1),
f) the electronic controls of the switching devices (18) are centrally combined in the microcomputer (23, 37) and
g) are constructed with the microcomputer (23, 37) as a microcomputer-control electronic unit which can be left permanently integrated at the central electrical unit (1),
h) the microcomputer control electronic unit of the central electrical unit (1) can be protected against voltage peaks, excessive voltages and negative impulses of the vehicle electrical system by one single fuse,
i) the microcomputer (23, 37) possesses a printed circuit board (24, 38), on which there are disposed at least one microprocessor (30, 39), constructed as an electronic computer, and having at least one programme memory (31, 40), at least one input and output unit (32, 41) and associated peripheral devices (33, 34, 42, 43),
j) the printed circuit board (24, 38) of the microcomputer (23, 37) is connected with the conductor paths (9) in the housing (2) of the central electrical unit (1).

2. Apparatus according to the preceding Claim, characterized in that the microcomputer (23, 37) is disposed in a plane above the conductor paths (9) opposite plugs (11, 11') provided on the lower part (3) of the housing (2).

3. Apparatus according to one of the preceding Claims, characterized in that the microcomputer (23, 37) is disposed in the region between sockets (15) which seat fuses (17) and the switching devices (18).

4. Apparatus according to one of the preceding Claims, characterized in that the microcomputer (23) is mounted recessed in a depression (21) of the housing (2).

5. Apparatus according to one of the preceding Claims, characterized in that the depression (21) of the housing (2) containing the microcomputer (23) is closed by means of a lid (22).

6. Apparatus according to one of the preceding Claims, characterized in that the printed circuit board (24) of the microcomputer (23) is secured on projections (29) at the lateral wall (28) of the depression (21) in the housing (2).

7. Apparatus according to one of the preceding Claims, characterized in that the printed circuit board (24) of the microcomputer (23) is firmly connected (soldered connection) by conductor webs (25) with the conductor paths (9) in the housing (2).

8. Apparatus according to one of the preceding Claims, characterized in that the printed circuit board (24) of the microcomputer (23) is releasably connected by plug components (26) with the conductor paths (9) in the housing (2).

9. Apparatus according to one of the preceding Claims, characterized in that the printed circuit board (24) of the microcomputer (23) can be contacted by means of a plug board (27), provided at the edge region, at one side of the depression (21) with the conductor paths (9) of the housing (2).

10. Apparatus according to one of the preceding Claims, characterized in that the microcomputer (37) comprising the printed circuit board (38) and the microprocessor (39) disposed thereon, the programme memory (40), the input and output unit (41) and the peripheral devices (42, 43), is disposed in a plug housing (44), which can be inserted with projecting plug pins (46) in plug seatings (50) of the housing (2).

11. Apparatus according to one of the preceding Claims, characterized in that the plug housing (44) of the microcomputer (37) is of substantially rectangular form and that the plug pins (46) are disposed on a base plate (45) of the plug housing (44) in parallel rows.

12. Apparatus according to one of the preceding Claims, characterized in that the printed circuit board (38) of the microcomputer (37) is orientated with its plane parallel to the plug pins (46) and perpendicular to the base plate (45) and is disposed in the plug housing (44) with its rear face at only a small distance from the one lateral wall (48).

13. Apparatus according to one of the preceding Claims, characterized in that the plug housing (44) containing the microcomputer (37) is inserted with the plug pins (46) on the upper part (4), opposite the plugs (11, 11') on the lower part (3) of the housing (2), in the region between the plug sockets (15) of the fuses (17) and of the switching devices (18) into the plug seatings (50) which are open here.

## Revendications

1. Dispositif pour véhicule automobile, comprenant:

a) une centrale électrique (1) pour le branchement central des composants électriques tels que des faisceaux de câble, des fiches, des fusibles (17) et des dispositifs de commutation (18), des commandes électroniques pour des utilisateurs électriques tels que des lampes ou projecteurs, des essuie-glace, des clignotants, des chauffages, des électrovannes,

b) la centrale électrique (1) comprend des chemins conducteurs (9) qui sont superposés dans plusieurs plans,

c) les chemins conducteurs (9) sont logés dans un boîtier (2) de la centrale électrique (1),

dispositif caractérisé par les caractéristiques suivantes connues partiellement :

d) les commandes électroniques sont séparées des dispositifs de commutation (18),

e) un micro-ordinateur (23, 37) est relié directement à la centrale électrique (1),

f) les commandes électroniques des dispositifs de commutation (18) sont réunies de manière centrale dans le micro-ordinateur (23, 37) et

g) au micro-ordinateur (23, 37) comme électronique de commande du micro-ordinateur, intégrée restant dans la centrale électrique (1),

h) l'électronique de commande-micro-ordinateur de la centrale électrique (1) est protégée par un seul fusible contre les pointes de tension, les surtensions et les impulsions négatives du réseau embarqué,

i) le micro-ordinateur (23, 37) comporte une plaque de circuit imprimé (24, 38) portant au moins un calculateur électronique en forme de microprocesseur (30, 39) avec au moins une mémoire de programme (31, 40) et au moins une unité d'entrée/sortie (32, 41) ainsi que des périphériques correspondants (33, 34, 42, 43),

j) la plaque de circuit imprimé (24, 38) du microordinateur (23, 37) est reliée aux chemins conducteurs (9) dans le boîtier (2) de la centrale électrique (1).

2. Dispositif selon la revendication prédédente caractérisé en ce que le micro-ordinateur (23, 37) est prévu dans un plan au-dessus des chemins conducteurs (9) par rapport aux fiches (11, 11") prévues sur la partie inférieure (3) du boîtier (2).

3. Dispositif selon l'une des revendications précédentes, caractérisé en ce que le microordinateur (23, 37) est prévu dans la zone comprise entre les fusibles (17) et les douilles d'enfichage (15) recevant les dispositifs de commutation (18).

4. Dispositif selon l'une des revendications précédentes, caractérisé en ce que le microordinateur (23) est logé de manière noyée dans une cavité (21) du boîtier (2).

5. Dispositif selon l'une des revendications précédentes, caractérisé en ce que la cavité (21) du boîtier (2) qui reçoit le micro-ordinateur (23) est fermée par un couvercle (22).

6. Dispositif selon l'une des revendications précédentes, caractérisé en ce que la plaque conductrice (24) du micro-ordinateur (23) est fixée sur des parties en saillie (29) sur la paroi latérale (28) de la cavité (21) à l'intérieur du boîtier (2).

7. Dispositif selon l'une des revendications précédentes, caractérisé en ce que la plaque à circuit imprimé (24) du micro-ordinateur (23) est reliée de manière solidaire (liaison par brasage) aux chemins conducteurs (9) dans le boîtier (2) par des entretoises conductrices (25).

8. Dispositif selon l'une des revendications précédentes, caractérisé en ce que la plaque à circuit imprimé (24) du micro-ordinateur (23) est reliée de manière amovible aux chemins conducteurs (9) du boîtier (2) par des pièces enfichables (26).

9. Dispositif selon l'une des revendications précédentes, caractérisé en ce que la plaque conductrice (24) du micro-ordinateur (23) est reliée par l'intermédiaire d'un longeron enfichable (27) prévu sur le bord à un côté de la cavité (21) aux chemins conducteurs (9) du boîtier (2), par contact.

10. Dispositif selon l'une des revendications précédentes, caractérisé en ce que le micro-ordinateur (37) est relié à la plaque conductrice (38) et au microprocesseur (39) prévu sur cette plaque, à la mémoire de programme (40), à l'unité d'entrée et de sortie (41) ainsi qu'aux périphériques (42, 43) dans un boîtier enfichable (44) qui se loge par des tiges d'enfichage (46) en saillie dans des logements d'enfichage (50) du boîtier (2).

11. Dispositif selon l'une des revendications précédentes, caractérisé en ce que le boîtier enfichable (44) du micro-ordinateur (37) présente une forme principalement rectangulaire et les tiges d'enfichage (46) sont disposées suivant des rangées parallèles sur la plaque de base (45) du boîtier enfichable (44).

12. Dispositif selon l'une des revendications précédentes, caractérisé en ce que la plaque conductrice (38) du micro-ordinateur (37) est alignée par son plan, parallèlement aux tiges enfichables (46) et perpendiculairement à la plaque de base (45) et son côté arrière se trouve qu'à une faible distance d'une paroi latérale (48) du boîtier enfichable (44).

13. Dispositif selon l'une des revendications précédentes, caractérisé en ce que le boîtier enfichable (44) contenant le micro-ordinateur (37) est logé par des tiges enfichables (46) dans la partie supérieure (4) en regard des fiches (11, 11') de la partie inférieure (3) du boîtier (2), dans la zone comprise entre les douilles d'enfichage (15) des fusibles (17) et des dispositifs de commutation (18) dans des logements d'enfichage (50) qui sont ouverts à cet endroit.

FIG. 1

FIG. 2

FIG. 3

FIG. 4

3